# EUROPEAN PATENT SPECIFICATION

(11) **EP 2 416 631 B1**
(45) Date of publication and mention of the grant of the patent: **17.02.2016**
(21) Application number: 11176666.3
(22) Date of filing: 05.08.2011
(51) Int. Cl.: H05K 1/14, H05K 1/18

(54) **Electrical household appliance comprising means for displaying an item of information**
Elektrisches Haushaltsgerät mit Mitteln zur Anzeige einer Informationseinheit
Appareil électroménager comprenant des moyens pour afficher un élément d'information

(30) Priority: 05.08.2010 IT RN20100046
(43) Date of publication of application: 08.02.2012
(60) Divisional application: 15198067.9
(73) Proprietor: Indesit Company S.p.A., 60044 Fabriano (AN) (IT)
(72) Inventor: Lippera, Mario, 60043 Cerreto d'Esi (AN) (IT); Duri, Sandro, 62025 Fiuminata (MC) (IT)
(74) Representative: Santonicola, Paolo

(56) References cited:
- EP-A2- 1 521 512
- WO-A1-2009/068518
- WO-A1-2012/086452
- DE-A1- 3 404 256
- DE-A1- 4 334 150
- GB-A- 2 022 872
- US-A1- 2003 205 250
- US-A1- 2006 189 195
- US-A1- 2009 223 256
- US-A1- 2010 128 447

## Description

This invention relates to an electrical household appliance comprising means for displaying information.

Known in the prior art are electrical household appliances furnished with LED display means.

More specifically, the display means comprise a PCB (an acronym for Printed Circuit Board). The PCB comprises a base and an electrical circuit printed on the base. A first face of the base has a plurality of LEDs on it, while a second face of the base, opposite the first face, has on it the pins for connection to an electronic card which controls the appliance. The pins are metal conductors 1 to 3 centimetres long and whose opposite ends are soldered respectively to the PCB and to the electronic control card. The electronic control card is thus rigidly connected to the PCB, with obvious limitations on the position of the electronic card relative to the display means.

The display means also comprise a front facia panel with slots made in it to define the graphical signs to be displayed.

Interposed between the front facia panel and the PCB, there is a plastic receptacle in which light-guides are formed to allow the light from the LEDs to diffuse to the slots made in the facia. Thus, when a LED switches on, the corresponding graphical symbol lights up.

DE4334150 discloses a method for manufacturing complete assemblies in a panel for telecommunications terminals, which consist of printed circuit hoards and carrier hoards, proposes that the printed circuit boards and carrier boards be connected to one another by means of tooth system and flat ribbon cables during the component-placcment, soldering and test states. The complete assemblies are separated from the panel, and the printed circuit boards and the carrier boards are subsequently separated at the tooth systems, which form material connections, by breaking off, immediately before installation in the terminal.

US200923256 relates to a drum type washing machine having an operation unit and a display unit provided, separately.

DE3404256 discloses an electrical house hold appliances with devices for the input of process parameters for the control of internal processes and for the indication of parameters and process faults which should be monitored.

GB2022872 discloses a programme selection apparatus for an electrical domestic apparatus e.g. a washing machine that comprises an LED or LCD display underlying a panel of touch sensitive witches A microprocessor causes items to be displayed which are then checked or selected by the operator by touching appropriate ones of the touch switches.

US2006189195 discloses a card edge connector system having a plug including a set of pad electrodes and a socket including a set of socket pins. Each electrode has a recess on contact surface of the electrode and each socket pin has a dimple on contact surface of the pin. The dimple of the socket pin is elastically urged to the recess of the plug electrode for obtaining a firm electric contact between the plug electrode and socket pin.

In this context, the technical purpose which forms the basis of this invention is to propose an electrical household appliance that overcomes the above mentioned drawbacks of the prior art.

More specifically, the aim of this invention is to provide an electrical household appliance where the position of the electronic card is free of the position of the printed circuit of the display means.

Another aim of the invention is to provide an electrical household appliance which allows the production costs of the display means to be limited.

The technical purpose indicated and the aims specified are substantially achieved by an electrical household appliance comprising the technical features described in one or more of the appended claims.

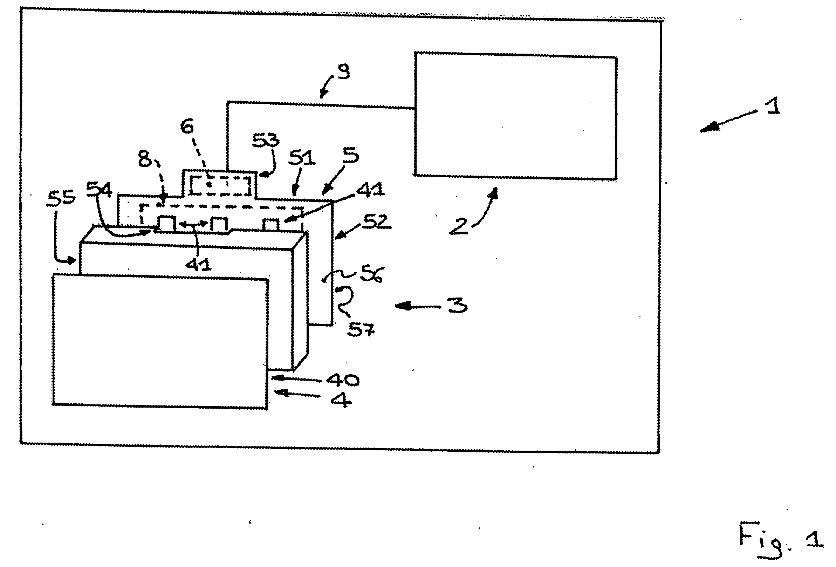

Further features and advantages of the invention are more apparent in the non-limiting description which follows of a preferred, non-limiting embodiment of an electrical household appliance, illustrated in the accompanying drawing, where Figure 1 is a schematic view of a first embodiment of this invention.

In the accompanying drawings, the reference numeral 1 denotes an electrical household appliance. The electrical household appliance comprises an electronic card 2. Advantageously, the electronic card 2 is the electronic card which controls the electrical household appliance 1. The electrical household appliance 1 also comprises means 3 for displaying an item of information, the display means 3 in turn comprising:
- a display unit 4 (for example, a screen which the user looks at to obtain the item of information);
- a printed circuit 8 and a first connector 6 which electrically connects the printed circuit 8 to the display means 3 outside it;
- a base 5 which mounts the printed circuit 8 and the first connector 6, the base 5 being located behind the display unit 4 with respect to an observation point in front of the display unit 4.

The base 5 and the printed circuit 8 together form what in technical jargon is called a PCB.

The electrical household appliance 1 also comprises electrical connection means 9 connecting the electronic card 2 and the first connector 6. Advantageously, the electronic card 2 also controls, besides the display means 3, other electronic components of the electrical household appliance 1 (if the electrical household appliance is a refrigerator, the electronic card 2 controls the cooling means such as, for example, the electric motor which drives the compressor, etc.).

The first connector 6 extends on a portion of a perimeter margin of the base 5. The first connector 6 extends at least on a portion of a perimeter margin of one face of the base 5. The face may be the first or the second face 56, 57 defined below. For example, perimeter margin might mean a border area running round the perimeter of the base 5 and extending inwards from the perimeter edge of the base 5 for an extension which is conveniently less than 2 centimetres, advantageously less than 1 centimetre, and preferably less than 0.4 centimetres.

The protrusion 53 extends uninterruptedly from a portion of the base 5 adjacent to it.

Conveniently, the base 5 extends substantially parallel to an imaginary reference (the imaginary reference plane coinciding with either the first or the second plane defined below).

The first connector 6 and the base 5 it is applied to protrude relative to the area defined by the orthogonal projection of the display unit 4 in the imaginary reference plane.

Conveniently, the base 5 comprises a first and a second large face 56, 57 lying in a first and a second imaginary reference plane, respectively. More specifically, the first face 56 is directed towards the display unit 4, while the second face 57 is opposite the first face 56 and is planar. Advantageously, the first and the second face 56 and 57 are substantially parallel to the display unit 4. The first and second imaginary planes are parallel. The first connector 6 and the base 5 it is applied to protrude relative to the two surfaces defined by the projections of the display unit 4 in the first and second planes, the projections being orthogonal to the first and second planes.

Conveniently, the first connector 6 is applied to a protrusion 53 of the base 5. Advantageously, but without limiting the invention, the protrusion 53 projects away from the rest of the base 5 for a length of between 0.4 and 2 centimetres. The first connector 6 is preferably a male connector and interacts with a female connector (not illustrated in Figure 1) outside the base 5 and forming part of the electrical household appliance 1. The protrusion 53 is co-planar with the rest of the base 5. The female connector forms part of the connection means 9. The connection means 9 allow the electronic card 2 to be located at a position independent of the position of the display means 3. The connection of the female connector to the electronic card 2 might be made through the agency of an intermediate electrical cable. Advantageously, the electronic card 2 is at a position remote from the display means 3. At a remote position means at a distance greater than at least 3 centimetres, advantageously greater than 5 centimetres, and preferably greater than 10 centimetres. Advantageously, the intermediate cable is more than 3 centimetres long, preferably more than 5 centimetres long, and advantageously more than 10 centimetres long. Still more advantageously, the orthogonal projection of the display means 3, orthogonal to the first and second planes, is not fully within the surface of the electronic card 2.

In this regard, an imaginary solid may be defined by the infinite extension of the base 5 in two opposite directions oriented along a straight line at right angles to the second face 57. In one embodiment, the card 2 does not intersect that solid. In an alternative embodiment, the card 2 identifies a first and a second part, forming part of the solid but outside the card 2 and between which the card 2 is at least partly interposed, the first and the second parts being connectable by an imaginary line inside the solid but outside the card 2.

Advantageously, the first connector 6 is of the type known in the technical jargon of the trade as "edge connector". Conveniently, the first connector 6 comprises at least one electric track applied to the base 5. The electric track comprises a metallic layer applied to the base 5 (typically by a process known as metallization). The electric track is located at one end of the printed circuit 8. Conveniently, a plurality of electric tracks are provided.

In an alternative embodiment, the first connector 6 made on the base 5 (preferably on the protrusion 53 of the base 5) is a female connector and partly houses the electrical connection means 9.

In that case, the first connector 6 comprises at least one metallized hole. Conveniently, the metallized hole is formed inside the base 5. The connection means 9 comprise at least one cable at least partly inserted in (and advantageously soldered in) the at least one metallized hole. The connection means 9 comprise a plurality of cables at least partly inserted in (and advantageously soldered in) corresponding metallized holes. Conveniently, the metallized holes are made inside the base 5.

In the embodiments described above, the base 5 is conveniently rigid. That is particularly advantageous in LED applications where cost containment is a preponderant factor. A rigid base 5 provides a support which facilitates application of the printed circuit 8 and of the first connector 6.

The base 5 might advantageously mount a second connector (this embodiment not being illustrated) electrically connecting the printed circuit 8 to the outside, the electrical connection means 9 connecting the electronic card 2 to the second connector.

Conveniently, the second connector, too, may be an edge connector. More specifically, the second connector may have one or more of the technical features described above for the first connector 6. Distributing the connectors between two or more points facilitates positioning of the electrical wiring. Indeed, positioning all the PCB connectors at a single point would create a strong constraint on all the electrical wiring which would have to lead to that point. Distributing the connectors between two or more points, on the other hand, could facilitate the spatial distribution of the connections.

In this regard, the first connector 6 and the second connector are applied to two different sides 51, 52 of the perimeter of the base 5.

The display means 3 comprise a receptacle 55, preferably of plastic, at least partly interposed between the display unit 4 and the base 5. Conveniently, the receptacle 55 comprises a groove 54 (advantageously a recess formed on a lateral face of the receptacle 55) from which the first connector 6 projects outwards. If there is also a second connector, a further groove for the second connector is advantageously provided.

The application of the above mentioned technology is particularly advantageous in the field of LED display means where cost containment is a fundamental aspect. In that case, the base 5 conveniently comprises a plurality of LEDs 41 directed towards the display unit 4.

The display unit 4 comprises a mask 40 with shaped slots forming the graphic signs to be displayed. The display unit 4 also comprises a front facia panel interposed between the mask 40 and the exterior of the electrical household appliance 1. The receptacle 55 is at least partly interposed between the mask 40 and the base 5. The receptacle 55 comprises one or more light guides (normally, there is one light guide for every graphical symbol to be illuminated). The light guides are in the form of cavities in the receptacle 55. Advantageously, the light guide cavities are filled with a translucent epoxy resin. Advantageously, the mask 40 is glued to the receptacle 55. With reference to Figure 1, the display unit 4, the receptacle 55 and the base 5 are illustrated in an exploded view and are connected to other blocks forming part of the electrical household appliance 1.

In an alternative embodiment (not illustrated) the display means 3 are based on liquid crystal or other display technology.

The embodiment illustrated in Figure 1, described above, allows the electronic card 2 to be placed at a position independent of (and more specifically, remote from) the base of the display means 3, thus overcoming a drawback of the prior art.

In this regard, an imaginary solid may be defined by the infinite extension of the base 5 in two opposite directions oriented along a straight line at right angles to the second face 57.

In one embodiment, the card 2 does not intersect that solid. In an alternative embodiment, the card 2 identifies a first and a second part, forming part of the solid but outside the card 2 and between which the card 2 is at least partly interposed. The first and the second part are connectable by an imaginary line inside the solid but outside the card 2. In that case, the electronic card 2 only partly cuts the solid. Conveniently, the electronic card 2 projects at least partly outside the solid.

This invention has important advantages.

First of all, it allows the position of the electronic card 2 to be made independent of the display means 3.

Another important advantage is linked to the possibility (at least in the embodiment illustrated in Figure 1) of eliminating the soldered connections between the contact pins and the printed circuit of the display means 3 and the electronic card 2. The embodiment of Figure 1 also allows a reduction of the dimensions of the display means 3 orthogonally to the display unit (since there are no rear contact pins).

## Claims

1. An electrical household appliance comprising:
i) an electronic control card (2);
ii) means (3) for displaying an item of information, the display means (3) in turn comprising:
- a display unit (4);
- a printed circuit (8) and a first connector (6) which electrically connects the printed circuit (8) to the outside;
- a base (5) which mounts the printed circuit (8) and the first connector (6), the base (5) being located behind the display unit (4) with respect to an observation point outside the electrical household appliance (1) and in front of display unit (4);
iii) electrical connection means (9) connecting the electronic control card (2) and the first connector (6);
wherein the first connector (6) extends on a perimeter portion of the base (5), the electrical household appliance being **characterized in that** the first connector (6) is applied to a protrusion (53) on the base (5), said protrusion (53) being co-planar with the rest of the base (5), and **in that** the display means (3) comprise a receptacle (55) at least partly interposed between the display unit (4) and the base (5), the receptacle (55) comprising a groove (54) from which the first connector (6) projects outwards.

2. The electrical household appliance according to claim 1, **characterized in that** the base (5) is hard.

3. The electrical household appliance according to claim 1 or 2, **characterized in that** the base (5) mounts a second connector electrically connecting the printed circuit (8) to the outside, the electrical connection means (9) connecting the electronic card (2) to the second connector.

4. The electrical household appliance according to claim 3, **characterized in that** the first connector (6) and the second connector are applied on two different sides (51, 52) of the perimeter of the base (5).

5. The electrical household appliance according to claim 1 or 2 or 3 or 4, **characterized in that**:
- the display means (3) are of the LED type, the base (5) comprising a plurality of LEDs (41) facing the display unit (4);
- the display unit (4) comprises a mask (40) with shaped slots forming the graphic signs to be displayed.

6. The electrical household appliance according to any of the claims from 1 to 4, **characterized in that** the display means (3) are of the liquid crystal type.

7. The electrical household appliance according to any of the previous claims, **characterized in that** the first connector (6) is a male connector and interacts with a female connector outside the base (5) and forming part of the electrical household appliance (1).

8. The electrical household appliance according to claim 7, **characterized in that** the first connector is an edge connector.

9. The electrical household appliance according to any of the claims from 1 to 6, **characterized in that** the first connector (6) is a female connector and comprises at least one metalized hole, the connection means (9) comprising at least one cable which is at least partly inserted and welded in the metalized hole.

## Patentansprüche

1. Elektrisches Haushaltsgerät, umfassend:
i) eine elektronische Steuerkarte (2);
ii) Mittel (3) zum Anzeigen eines Informationsobjekts, wobei die Anzeigemittel (3) wiederum umfassen:
- eine Anzeigeeinheit (4);
- eine gedruckte Schaltung (8) und ein erstes Verbindungselement (6), welches die gedruckte Schaltung (8) elektrisch mit der Außenseite verbindet;
- eine Basis (5), welche die gedruckte Schaltung (8) und das erste Verbindungselement (6) trägt, wobei die Basis (5) bezüglich eines Beobachtungspunkts außerhalb des elektrischen Haushaltsgeräts (1) hinter der Anzeigeeinheit (4) und vor der Anzeigeeinheit (4) liegt;
iii) elektrische Verbindungsmittel (9), welche die elektronische Steuerkarte (2) und das erste Verbindungselement (6) verbinden;
wobei das erste Verbindungselement (6) sich an einem Umfangsabschnitt der Basis (5) erstreckt, wobei das elektrische Haushaltsgerät **dadurch gekennzeichnet ist, dass** das erste Verbindungselement an einem Vorsprung (53) an der Basis (5) angebracht ist, wobei der Vorsprung (53) koplanar mit dem Rest der Basis (5) ist, und dadurch, dass die Anzeigemittel (3) eine Aufnahme (55) umfassen, welche wenigstens teilweise zwischen der Anzeigeeinheit (4) und der Basis (5) eingefügt ist, wobei die Aufnahme (55) eine Nut (54) umfasst, von welcher aus das erste Verbindungselement (6) nach außen vorsteht.

2. Elektrisches Haushaltsgerät nach Anspruch 1, **dadurch gekennzeichnet, dass** die Basis (5) hart ist.

3. Elektrisches Haushaltsgerät nach Anspruch 1 oder 2, **dadurch gekennzeichnet, dass** die Basis (5) ein zweites Verbindungselement trägt, welches die gedruckte Schaltung (8) elektrisch mit der Außenseite verbindet, wobei die elektrischen Verbindungsmittel (9) die elektronische Karte (2) mit dem zweiten Verbindungselement verbinden.

4. Elektrisches Haushaltsgerät nach Anspruch 3, **dadurch gekennzeichnet, dass** das erste Verbindungselement (6) und das zweite Verbindungselement an zwei verschiedenen Seiten (51, 52) des Umfangs der Basis (5) angebracht sind.

5. Elektrisches Haushaltsgerät nach Anspruch 1 oder 2 oder 3 oder 4, **dadurch gekennzeichnet, dass**:
- die Anzeigemittel (3) vom LED-Typ sind, wobei die Basis (5) eine Mehrzahl von LEDs (41) umfasst, welche zu der Anzeigeeinheit (4) weisen;
- die Anzeigeeinheit (4) eine Maske (40) mit geformten Schlitzen umfasst, welche die anzuzeigenden graphischen Zeichen bilden.

6. Elektrisches Haushaltsgerät nach einem der Ansprüche 1 bis 4, **dadurch gekennzeichnet, dass** die Anzeigemittel (3) vom Flüssigkristall-Typ sind.

7. Elektrisches Haushaltsgerät nach einem der vorhergehenden Ansprüche, **dadurch gekennzeichnet, dass** das erste Verbindungselement (6) ein männliches Verbindungselement ist und mit einem weiblichen Verbindungselement außerhalb der Basis (5) zusammenwirkt und einen Teil des elektrischen Haushaltsgeräts (1) bildet.

8. Elektrisches Haushaltsgerät nach Anspruch 7, **dadurch gekennzeichnet, dass** das erste Verbindungselement ein Rand-Verbindungselement ist.

9. Elektrisches Haushaltsgerät nach einem der Ansprüche 1 bis 6, **dadurch gekennzeichnet, dass** das erste Verbindungselement (6) ein weibliches Verbindungselement ist und wenigstens ein metallisiertes Loch umfasst, wobei die Verbindungsmittel (9) wenigstens ein Kabel umfassen, welches wenigstens teilweise in das metallisierte Loch eingefügt und geschweißt ist.

## Revendications

1. Appareil électroménager comprenant :
i) une carte de commande électronique (2) ;
ii) des moyens (3) pour afficher un élément d'information, les moyens d'affichage (3) comportant, à leur tour :
- une unité d'affichage (4) ;
- un circuit imprimé (8) et un premier connecteur (6) qui connecte électriquement le circuit imprimé (8) avec l'extérieur ;
- une base (5) sur laquelle sont montés le circuit imprimé (8) et le premier connecteur (6), la base (5) étant située derrière l'unité d'affichage (4) par rapport à un point d'observation extérieur à l'appareil électroménager (1) et en face de l'unité d'affichage (4) ;
iii) des moyens de connexion électrique (9) connectant la carte de commande électronique (2) et le premier connecteur (6) ;
dans lequel le premier connecteur (6) s'étend sur une partie du périmètre de la base (5), l'appareil électroménager étant **caractérisé en ce que** le premier connecteur (6) est appliqué sur une partie en saillie (53) de la base (5), ladite partie en saillie (53) étant coplanaire avec le reste de la base (5), et **en ce que** les moyens d'affichage (3) comprennent un logement (55) interposé, au moins partiellement, entre l'unité d'affichage (4) et la base (5), le logement (55) comportant une gorge (54) à partir de laquelle le premier connecteur (6) s'avance vers l'extérieur.

2. Appareil électroménager selon la revendication 1, **caractérisé en ce que** la base (5) est dure.

3. Appareil électroménager selon la revendication 1 ou 2, **caractérisé en ce que** sur la base (5) est monté un second connecteur reliant électriquement le circuit imprimé (8) à l'extérieur, les moyens de connexion électrique (9) connectant la carte électronique (2) au second connecteur.

4. Appareil électroménager selon la revendication 3, **caractérisé en ce que** le premier connecteur (6) et le second connecteur sont appliqués sur deux côtés différents (51, 52) du périmètre de la base (5).

5. Appareil électroménager selon la revendication 1 ou 2 ou 3 ou 4, **caractérisé en ce que** :
- les moyens d'affichage (3) sont du type LED, la base (5) comportant une pluralité de LED (41) faisant face à l'unité d'affichage (4) ;
- l'unité d'affichage (4) comporte un masque (40) présentant des fentes configurées formant les signes graphiques à afficher.

6. Appareil électroménager selon l'une quelconque des revendications 1 à 4, **caractérisé en ce que** les moyens d'affichage (3) sont du type à cristaux liquides.

7. Appareil électroménager selon l'une quelconque des revendications précédentes, **caractérisé en ce que** le premier connecteur (6) est un connecteur mâle et il interagit avec un connecteur femelle extérieur à la base (5) et faisant partie de l'appareil électroménager (1).

8. Appareil électroménager selon la revendication 7, **caractérisé en ce que** le premier connecteur est un connecteur de bord.

9. Appareil électroménager selon l'une quelconque des revendications 1 à 6, **caractérisé en ce que** le premier connecteur (6) est un connecteur femelle et comporte au moins un trou métallisé, les moyens de connexion (9) comportant au moins un câble qui est, au moins partiellement, inséré et soudé dans le trou métallisé.
